(19) Europäisches Patentamt

European Patent Office

Office européen des brevets

(11) EP 0 738 929 A2

## (12) EUROPEAN PATENT APPLICATION

(43) Date of publication:
23.10.1996 Bulletin 1996/43

(51) Int. Cl.$^6$: **G03F 7/09**, G03F 7/029

(21) Application number: 96106125.6

(22) Date of filing: 18.04.1996

(84) Designated Contracting States:
DE FR GB NL

(30) Priority: 19.04.1995 JP 93795/95

(71) Applicant: **Mitsubishi Chemical Corporation**
**Chiyoda-ku, Tokyo (JP)**

(72) Inventor: **Tsuchiyama, Masaaki,**
**Mitsubishi Chemical Corp.**
**Tokyo (JP)**

(74) Representative: **TER MEER - MÜLLER -**
**STEINMEISTER & PARTNER**
**Mauerkircherstrasse 45**
**81679 München (DE)**

### (54) Photopolymerizable sensitive material

(57) A photopolymerizable sensitive material which comprises a support, a photopolymerizable sensitive layer comprising (A) an addition polymerizable compound having at least one ethylenically unsaturated bond, (B) a photopolymerization initiator to be activated by active light rays and (C) a polymer binder, formed on the support, and a protective layer formed thereon, wherein said protective layer comprises at least (a) a polyvinyl alcohol and/or a polyvinyl alcohol derivative, and (b) a polyvinyl pyrrolidone having a weight average molecular weight of from 20,000 to 500,000 and/or a vinyl pyrrolidone copolymer containing at least 50 mol% of vinyl pyrrolidone as a copolymer component and having a weight average molecular weight of from 10,000 to 400,000, and the proportion of component (a) in the total amount of components (a) and (b) is from 25 to 75 wt%.

Printed by Rank Xerox (UK) Business Services
2.13.8/3.4

## Description

The present invention relates to a photopolymerizable composition useful for a photosensitive lithographic printing plate or for a photoresist. Particularly, it relates to a photopolymerizable sensitive material which is highly sensitive to light rays in the visible light range and which is excellent in developability, ink-affinity, scratch resistance of the protective layer, storage stability and printing resistance.

Heretofore, a number of photopolymerizable sensitive materials having protective layers have been known and disclosed, for example, in Japanese Unexamined Patent Publications No. 103702/1974, No. 24703/1977, No. 263141/1985, No. 285444/1986, No. 79440/1987, No. 223747/1987 and No. 103051/1990. However, the performance of such conventional photopolymerizable sensitive materials has not been fully satisfactory, and particularly, improvement has been desired with respect to the storage stability, scratch resistance of the protective layer, etc.

In recent years, sensitive materials with high sensitivity employing photopolymerizable sensitive materials have been studied in various application fields. Among them, direct plate forming by laser may be mentioned as a system which may soon be practically employed, whereby a highly sensitive photopolymer suitable for the oscillation wavelength of a laser e.g. 488 nm of an argon ion laser, is strongly desired. In such direct plate forming by laser, plate forming is carried out by means of a visible light laser exposure apparatus having an automatic transporting mechanism, and high scratch resistance of the protective layer is accordingly required for the transportation system.

However, conventional photopolymerization sensitive materials have been inadequate in the balance of various properties such as scratch resistance of the protective layer, developability, ink-affinity, sensitivity and printing resistance. Namely, it is an object of the present invention to provide a photopolymerizable sensitive material which is highly sensitive to light rays in the visible light range and which is excellent in developability, ink-affinity, scratch resistance of the protective layer, storage stability and printing resistance. The present inventors have conducted extensive studies to solve the above-mentioned problems of the prior art and as a result, have found it possible to accomplish the desired object with a photopolymerizable sensitive material having a protective layer comprising certain specific components. The present invention has been accomplished on the basis of this discovery.

That is, the present invention provides a photopolymerizable sensitive material which comprises a support, a photopolymerizable sensitive layer comprising (A) an addition polymerizable compound having at least one ethylenically unsaturated bond, (B) a photopolymerization initiator to be activated by active light rays and (C) a polymer binder, formed on the support, and a protective layer formed thereon, wherein said protective layer comprises at least (a) a polyvinyl alcohol and/or a polyvinyl alcohol derivative, and (b) a polyvinyl pyrrolidone having a weight average molecular weight of from 20,000 to 500,000 and/or a vinyl pyrrolidone copolymer containing at least 50 mol% of vinyl pyrrolidone as a copolymer component and having a weight average molecular weight of from 10,000 to 400,000, and the proportion of component (a) in the total amount of components (a) and (b) is from 25 to 75 wt%.

Now, the present invention will be described in detail with reference to the preferred embodiments.

The addition polymerizable compound having at least one ethylenically unsaturated double bond (hereinafter referred to simply as "ethylenic compound") which is a first essential component in the photopolymerizable sensitive layer of the present invention, is a compound having an ethylenically unsaturated double bond, which is capable of undergoing addition polymerization and being cured by the action of the photopolymerization initiator as a second essential component, when the photopolymerizable sensitive material is irradiated with active light rays. For example, it may be a monomer having such a double bond or a polymer having an ethylenically unsaturated double bond in its side chain or main chain. In the present invention, the monomer is meant for a substance as opposed to a so-called polymer substance and includes dimers, trimers and oligomers in addition to monomers in a narrow sense.

The monomer having an ethylenically unsaturated bond includes, for example, an unsaturated carboxylic acid, an ester of an unsaturated carboxylic acid with an aliphatic polyhydroxy compound, an ester of an unsaturated carboxylic acid with an aromatic polyhydroxy compound and an ester obtained by the esterification reaction of an unsaturated carboxylic acid and a polybasic carboxylic acid with a polyhydroxy compound such as the above-mentioned aliphatic polyhydroxy compound or aromatic polyhydroxy compound.

The above-mentioned ester of an unsaturated carboxylic acid with an aliphatic polyhydroxy compound is not particularly limited and includes acrylic acid esters such as ethylene glycol diacrylate, triethylene glycol diacrylate, trimethylolpropane triacrylate, trimethylolethane triacrylate, pentaerythritol diacrylate, pentaerythritol triacrylate, pentaerythritol tetracrylate, dipentaerythritol tetracrylate, dipentaerythritol pentacrylate, dipentaerythritol hexacrylate and glycerol acrylate; methacrylic acid esters corresponding to the above examples wherein "acrylate" is changed to "methacrylate"; itaconic acid esters corresponding to the above examples wherein "acrylate" is likewise changed to "itaconate"; crotonic acid esters corresponding to the above examples wherein "acrylate" is likewise changed to "crotonate"; and maleic acid esters corresponding to the above examples wherein "acrylate" is likewise changed to "maleate".

The ester of an unsaturated carboxylic acid with an aromatic polyhydroxy compound includes, for example, hydroquinone diacrylate, hydroquinone dimethacrylate, resorcinol diacrylate, resorcinol dimethacrylate and pyrogallol triacrylate.

The ester obtained by the esterification reaction of an unsaturated carboxylic acid with a polyhydroxy compound may not necessarily be a single compound. Typical specific examples include a condensation product of acrylic acid, phthalic acid and ethylene glycol, a condensation product of acrylic acid, maleic acid and diethylene glycol, a condensation product of methacrylic acid, terephthalic acid and pentaerythritol, and a condensation product of acrylic acid, adipic acid, butane diol and glycerol.

Other examples of the ethylenic compound which may be used in the present invention include urethane acrylates such as an addition reaction product of tolylene diisocyanate with hydroxyethyl acrylate; epoxy acrylates such as an addition reaction product of a diepoxy compound with hydroxyethyl acrylate; acrylamides such as ethylenebisacrylamide; allyl esters such as diallyl phthalate; and vinyl group-containing compounds such as divinyl phthalate.

The polymer having an ethylenically unsaturated bond on the main chain includes, for example, a polyester obtained by the polycondensation reaction of an unsaturated dibasic carboxylic acid with a dihydroxy compound, and a polyamide obtained by the polycondensation reaction of an unsaturated dibasic carboxylic acid with a diamine. The polymer having an ethylenically unsaturated bond at the side chain may be a condensation polymer of a dibasic carboxylic acid having an unsaturated bond at the side chain such as itaconic acid, propylidenesuccinic acid or ethylidenemalonic acid with a dihydroxy or diamine compound. Further, a polymer having a functional group having a reactivity such as a hydroxyl group or a halogenated methyl group in the side chain, such as a polymer obtained by a polymer reaction of e.g. polyvinyl alcohol, poly(2-hydroxyethyl methacrylate) or polyepichlorohydrin with an unsaturated carboxylic acid such as acrylic acid, methacrylic acid or crotonic acid, may also be suitable for use.

Among the above-mentioned ethylenic compounds, monomers of acrylic acid esters or methacrylic acid esters are particularly suitable for use.

Now, the photopolymerization initiator as a second essential component of the photopolymerizable sensitive layer of the present invention will be described.

As the photopolymerization initiator, any initiator which is capable of initiating the polymerization of the above-mentioned compound having at least one ethylenically unsaturated bond, can be used. Particularly, any initiator may be used so long as it is the one having photosensitivity to light rays in the visible light range, and it may be a combination of a sensitizer and an activating agent. As an activating agent which forms active radicals by a certain action with a sensitizer excited by irradiation, a hexaarylbiimidazole compound, a titanocene compound, a halogenated hydrocarbon derivative, a diaryl iodonium salt or an organic peroxide may, for example be mentioned. Among them, it is preferred to use a hexaarylbiimidazole compound or a titanocene compound, whereby the sensitivity of the photopolymerizable sensitive layer, the stability and the adhesion of the coating film to the substrate will be good.

As the hexaarylbiimidazole compound, various compounds may be used so long as they have a hexaarylbiimidazole backbone in their structures. For example, 2,2'-bis(o-chlorophenyl)-4,4',5,5'-tetra(p-fluorophenyl)biimidazole, 2,2'-bis(o-bromophenyl)-4,4',5,5'-tetra(p-iodophenyl)biimidazole, 2,2'-bis(o-chlorophenyl)-4,4',5,5'-tetra(p-chloronaphthyl)biimidazole, 2,2'-bis(o-chlorophenyl)-4,4',5,5'-tetra(p-chlorophenyl)biimidazole, 2,2'-bis(o-bromophenyl)-4,4',5,5'-tetra(p-chloro-p-methoxyphenyl)biimidazole, 2,2'-bis(o-chlorophenyl)-4,4',5,5'-tetra(o,p-dichlorophenyl)biimidazole, 2,2'-bis(o-chlorophenyl)-4,4',5,5'-tetra(o,p-dibromophenyl)biimidazole, 2,2'-bis(o-bromophenyl)-4,4',5,5'-tetra(o,p-dichlorophenyl)biimidazole, and 2,2'-bis(o,p-dichlorophenyl)-4,4',5,5'-tetra(o,p-dichlorophenyl)biimidazole, may be mentioned.

These hexaarylbiimidazole compounds may be used in combination with other types of biimidazole compounds, as the case requires. Such biimidazole compounds can be easily prepared, for example, by the methods disclosed in Bull. Chem. Soc. Japan, 33,565 (1960) and J. Org. Chem. 36[16]2262 (1971).

As the titanocene compound, various compounds may be employed. Specifically, a titanium complex having a biscyclopentadienyl group may be mentioned, and a compound which forms active radicals by a certain action with a sensitizer excited by irradiation, may be mentioned. For example, the titanocene compound may suitably be selected from various titanocene compounds disclosed in e.g. Japanese Unexamined Patent Publications No. 152396/1984 and No. 151197/1986. More specifically, di-cyclopentadienyl-Ti-di-chloride, di-cyclopentadienyl-Ti-bis-phenyl, di-cyclopentadienyl-Ti-bis-2,3,4,5,6-pentafluorophenyl-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-bis-2,6-di-fluorophen-1-yl, di-cyclopentadienyl-Ti-bis-2,4-difluorophen-1-yl, di-methylcyclopentadienyl-Ti-bis-2,3,4,5,6-pentafluorophen-1-yl, di-methylcyclopentadienyl-Ti-bis-2,6-difluorophen-1-yl, and di-cyclopentadienyl-Ti-bis-2,6-difluoro-3-(pyrr-1-yl)-phen-1-yl, may, for example, be mentioned.

Now, the sensitizer in the photopolymerization initiator will be described.

The sensitizer in the present invention means a compound which, when present together with the above-mentioned photopolymerization initiator, is capable of forming active radicals effectively by irradiation of visible light rays.

Typical examples of such a sensitizer include a triphenylmethane leuco dye such as Leuco Crystal Violet or Leuco Malachite Green, or a photoreducible dye such as Erythrosin or Eosine Y, as disclosed in e.g. U.S. Patent 3,479,185, aminophenyl ketones such as Michler's ketone and aminostyryl ketone, as disclosed in U.S. Patents 3,549,367 and 3,652,275, β-diketones as disclosed in U.S. Patent 3,844,790, indanones as disclosed in U.S. Patent 4,162,162, ketocumarines as disclosed in Japanese Unexamined Patent Publication No. 112681/1977, amino styrene derivatives or aminophenyl butadiene derivatives, as disclosed in Japanese Unexamined Patent Publication No. 56403/1984, aminophenyl heterocyclic compounds as disclosed in U.S. Patent 4,594,310, julolidine heterocyclic compounds as disclosed in U.S. Patent 4,966,830, and pyrromethene dyes as disclosed in Japanese Unexamined Patent Publication No. 241388/1993.

Now, the polymer binder (C) as a third essential component of the photopolymerizable sensitive layer of the present invention will be described.

This is a component for imparting a film forming ability and a viscosity-regulating ability. Specific examples thereof include (meth)acrylic acid, their esters, homopolymers or copolymers of maleic acid, acrylonitrile, styrene, vinyl acetate and vinylidene chloride as well as polyethylene oxide, polyvinyl pyrrolidone, polyamide, polyurethane, polyethylene terephthalate, acetyl cellulose and polyvinyl butyral. Among them, the one containing an unsaturated carboxylic acid such as (meth)acrylic acid as copolymer units, is preferred, since it has good developability with alkaline water. Particularly preferred is a polymer binder containing from 2 to 30 mol%, more preferably from 5 to 20 mol%, of an unsaturated carboxylic acid as a copolymer component. If the content of the unsaturated carboxylic acid is less than 2 mol%, the developability with alkaline water tends to be inadequate, and if it exceeds 30 mol%, the printing resistance and the ink-affinity of the photopolymerizable sensitive material of the present invention tend to be poor.

Further, the photopolymerizable sensitive layer of the present invention preferably has a contact angle to water of at least 60°. If the contact angle to water is less than 60°, the ink-affinity of the photopolymerizable sensitive material of the present invention tends to be poor.

In the foregoing, the main constituting components of the photopolymerizable sensitive layer of the present invention have been described in detail, and their suitable proportions for use are such that to 100 parts by weight of the polymerizable ethylenic unsaturated compound, in the photopolymerization initiator, the sensitizer is preferably from 0.01 to 20 parts by weight, more preferably from 0.05 to 10 parts by weight, the activating agent is preferably from 0.1 to 80 parts by weight, more preferably from 0.5 to 50 parts by weight, and the polymer binder is preferably from 10 to 400 parts by weight, more preferably from 20 to 200 parts by weight.

In addition to the above described constituting components, other materials may be incorporated to the photopolymerizable sensitive layer of the present invention depending upon the particular purpose. For example, a thermal polymerization inhibitor such as hydroquinone, p-methoxyphenol or 2,6-di-t-butyl p-cresol, a coloring agent such an organic or inorganic dye or pigment, a plasticizer such as dioctyl phthalate, didodecyl phthalate or tricresyl phosphate, a sensitivity characteristic-improving agent such as tertiary amine or thiol, and other additives such as a colorant precursor, may be incorporated.

Preferred amounts of such various additives are such that to 100 parts by weight of the ethylenic compound, the thermal polymerization inhibitor is at most 2 parts by weight, the coloring agent is at most 20 parts by weight, the plasticizer is at most 40 parts by weight, and the colorant precursor is at most 30 parts by weight.

The photopolymerizable sensitive layer of the present invention may be formed by coating the composition on the substrate without using a solvent or after being diluted with a suitable solvent, followed by drying. The coating may be carried out by a conventional method such as dip coating, coating by a coating rod, spinner coating, spray coating or roll coating.

Now, the protective layer of the present invention will be described. In the present invention, the protective layer is provided as an oxygen-shielding layer to prevent the photopolymerizable sensitive layer from having its polymerization hindered by the action of oxygen. The protective layer of the present invention comprises at least (a) a polyvinyl alcohol and/or a polyvinyl alcohol derivative, and (b) a polyvinyl pyrrolidone having a weight average molecular weight of 20,000 to 500,000 and/or a vinyl pyrrolidone copolymer containing at least 50 mol% of vinyl pyrrolidone units and having a weight average molecular weight of from 10,000 to 400,000, whereby the proportion of component (a) in the total amount of components (a) and (b) is from 25 to 75 wt%.

The polyvinyl alcohol of component (a) can be obtained by saponifying polyvinyl acetate with an alkali, acid or aqueous ammonia. In the present invention, the weight average molecular weight of the polyvinyl alcohol is preferably from 4,000 to 100,000, more preferably from 10,000 to 50,000. If the weight average molecular weight is less than 4,000, the film strength tends to be weak, and scratch resistance of the protective layer tends to be poor. On the other hand, if it exceeds 100,000, the developability tends to be poor. The saponification degree of the polyvinyl alcohol is preferably from 75 to 99 mol%, more preferably from 85 to 95 mol%. If the saponification degree is less than 75 mol% or more than 99 mol%, the solubility in water or alkaline water tends to be poor, and the developability tends to be poor. Further, a derivative of a polyvinyl alcohol is also useful which has the weight average molecular weight and the saponification degree within the above ranges and which is soluble in water or in a mixture of water and a water-miscible organic solvent. Such a derivative may, for example, be a partially acetal-modified polyvinyl alcohol, a modified polyvinyl alcohol cation-modified by a quaternary ammonium salt or a modified polyvinyl alcohol anion-modified by e.g. sodium sulfonate. Further, a combination of the above polyvinyl alcohol and one or more of its derivatives, may be employed. The proportion of component (a) in the total amount of components (a) and (b) in the protective layer is required to be from 25 to 75 wt%, preferably from 30 to 70 wt%, more preferably from 35 to 65 wt%. If the proportion is less than 25 wt%, the sensitivity tends to be low, such being undesirable. If it exceeds 75 wt%, the adhesion to the photopolymerizable sensitive layer tends to be poor, and scratch resistance of the protective layer tends to be poor, such being undesirable.

In the present invention, the weight average molecular weight of the polyvinyl pyrrolidone is required to be within a range of from 20,000 to 500,000, preferably from 30,000 to 250,000. If it is less than 20,000, the film strength tends to be weak, and scratch resistance of the protective layer tends to be poor, such being undesirable. If it exceeds 500,000, the developability and scratch resistance of the protective layer tend to be poor, such being undesirable. The polyvinyl pyrrolidone can be produced by polymerizing N-vinyl-2-pyrrolidone by conventional radical polymerization. A typical method for the production may be a method wherein N-vinyl-2-pyrrolidone is made into an aqueous solution and polymerized in the presence of a small amount of ammonia by means of a hydrogen peroxide catalyst. Further, in the present invention, a vinyl pyrrolidone copolymer containing at least 50 mol% of vinyl pyrrolidone as a copolymer component can also be suitably employed. Such a vinyl pyrrolidone copolymer can be produced by a conventional radical polymerization method. Various materials may be used as the copolymer component, but particularly preferred is vinyl acetate. The weight average molecular weight of this vinyl pyrrolidone copolymer is required to be within a range of from 10,000 to 400,000, preferably from 30,000 to 250,000. If it is less than 10,000, the film strength tends to be poor, and scratch resistance of the productive layer tends to be poor, such being undesirable. On the other hand, if it exceeds 400,000, the developability and scratch resistance of the protective layer tend to be poor, such being undesirable. Further, the above polyvinyl pyrrolidone and one or more of the vinyl pyrrolidone copolymers may be used in combination.

In the present invention, the coated amount of the protective layer is preferably from 1 g/m$^2$ to 10 g/m$^2$, more preferably from 2 g/m$^2$ to 7 g/m$^2$. When the coated amount is at least 1 g/m$^2$, the sensitivity of the photopolymerizable sensitive material will be high, and scratch resistance of the protective layer will be good. When it is not higher than 10 g/m$^2$, the developability will be good.

The protective layer of the present invention is formed by dissolving the composition in water, or in a mixed solvent of water with a water-miscible organic solvent, followed by coating and drying on a substrate. The coating can be carried out by a conventional method for coating a photopolymerizable sensitive layer.

To the protective layer of the present invention, in addition to the above-mentioned constituting components, other materials may be incorporated depending upon its particular purpose. For example, a water-soluble polymer such as polyethylene oxide or a cellulose derivative, a nonionic surfactant such as polyoxyethylenealkylphenyl ether, an anionic surfactant such as sodium dodecylbenzene sulfonate, a cationic surfactant such as lauryltrimethylammonium chloride, a dye, and a plasticizer, may be incorporated, depending upon the purpose. A preferred content of the above-mentioned various additives is at most 10 wt%, more preferably at most 5 wt%, in the protective layer.

As the support for the photopolymerizable sensitive material of the present invention, a plastic, paper or metal may, for example, be mentioned. When it is used as a photosensitive lithographic printing plate, an aluminum support is preferably used.

The surface of this aluminum support is preferably treated by surface roughening treatment for the purpose improving the water-maintaining property and the adhesion to the sensitive layer. The surface roughening method may, for example, be a conventional method such as a brush polishing method, a ball polishing method, an electrolytic etching method, a chemical etching method, a liquid horning method or a sand blasting method, or a combination of such methods. Preferably, a brush polishing method, an electrolytic etching method, a chemical etching method or a liquid horning method, may be employed. Among them, particularly preferred is a surface roughening method by a brush polishing method or an electrolytic etching method. The aluminum support having the surface treated by the surface roughening treatment may be subjected to desmatte treatment by an acid or alkaline aqueous solution, as the case requires, and then preferably subjected to anodizing treatment. Particularly preferably, it may be treated in a bath containing sulfuric acid or phosphoric acid. Further additional surface treatment may be applied, such as treatment with an alkali silicate or hot water, or dipping in an aqueous solution of a water-soluble polymer or potassium fluorinate zirconate, as the case requires.

The light source for exposure applicable to the photopolymerizable sensitive material of the present invention is not particularly limited. For example, carbon arc, a high pressure mercury lamp, a xenon lamp, a metal halide lamp, a fluorescent lamp, a tungsten lamp, a halogen lamp, a helium cadmium laser, an argon ion laser, a YAG laser, or a helium neon laser may suitably be used. As the light source for direct plate forming by laser, an argon ion laser or a YAG laser is particularly preferred. A laser exposure apparatus having an automatic transporting mechanism is preferably employed.

After the image exposure with such a light source, the photopolymerizable sensitive material of the present invention is developed, for example, by means of an aqueous solution containing a surfactant and an alkali to form an image on the support. This aqueous solution may further contain an organic solvent, a buffer, a dye or a pigment. A suitable alkali agent includes, for example, an inorganic alkali agent such as sodium silicate, potassium silicate, sodium hydroxide, potassium hydroxide, lithium hydroxide, sodium tertiary phosphate, sodium secondary phosphate, sodium carbonate, potassium carbonate, or sodium bicarbonate, and an organic amine compound such as trimethylamine, diethylamine, monoisopropylamine, n-butylamine, monoethanolamine, diethanolamine, or triethanolamine. These agents may be used alone or in combination. The surfactant may, for example, be nonionic surfactants such as polyoxyethylene alkyl ethers, polyoxyethylenealkylaryl ethers, polyoxyethylene alkyl esters, sorbitan alkyl esters, or monoglyceridealkyl esters; anionic surfactants such as alkylbenzene sulfonates, alkylnaphthalene sulfonates, alkyl sulfates, alkyl sulfonates, or sulfosuccinic acid esters; or amphoteric surfactants such as alkyl betaines, or amino acids. The organic solvents which may be added as the case requires, may, for example, be isopropyl alcohol, benzyl alcohol, ethylcellosolve, butylcellosolve, phenyl cellosolve, propylene glycol, or diacetone alcohol.

Now, the present invention will be described in further detail with reference to Examples and Comparative Examples. However, it should be understood that the present invention is by no means restricted to such specific Examples.

EXAMPLES 1 TO 8 AND COMPARATIVE EXAMPLES 1 TO 8

The following coating liquid 1 for photopolymerizable sensitive layer was whirl-coated on a grained and anodized aluminum support so that the dried film thickness would be 2 $g/m^2$, followed by drying. Further, a coating liquid for protective layer having a composition as identified in Table 1 was whirl-coated thereon so that the dried film thickness would be 5 $g/m^2$, followed by drying to obtain a photosensitive lithographic printing plate. The obtained photosensitive lithographic printing plate was evaluated with respect to the following items. The results are shown in Tables 1 and 2.

## Coating liquid 1 for photopolymerizable sensitive layer

| | |
|---|---|
| Trimethylolpropane triacrylate | 50 parts |
| Polymer binder (copolymer of isobutyl methacrylate/isobutyl acrylate/ methyl acrylate/methacrylic acid = 40/10/35/15 mol ratio, weight average molecular weight: 100,000) | 50 parts |
| Compound of the following formula (S-1) | 1.5 parts |
| 2,2'-Bis(o-chlorophenyl)-4,4',5,5'-tetra (p-carboethoxyphenyl)biimidazole | 13 parts |
| 2-Mercaptobenzothiazole | 10 parts |
| Victoria Pure Blue BOH (manufactured by Hodogaya Kogyo K.K.) | 0.5 part |
| Methylethyl ketone | 90 parts |

(S-1)

Initial sensitivity

The photosensitive lithographic printing plate was subjected to exposure by means of a diffraction spectral irradiation apparatus (RM-23, manufactured by Narumi K.K.) and then, developed with a developer prepared by diluting five times with water, a developer stock solution containing 20 wt% of potassium hydroxide, 75 wt% of potassium silicate and 5 wt% of a sodium alkylnaphthalene sulfonate (Pelex NBL, tradename, manufactured by Kao Corporation). From the height of the obtained cured image, the amount of light energy required for photocuring by light rays with a wavelength of 488 nm was determined.

Storage stability

The photosensitive lithographic printing plate was stored for one week in a constant temperature and humidity chamber adjusted to a relative humidity of 0%, and the sensitivity was measured in the same manner as for the initial sensitivity to determine the sensitivity-maintaining ratio. The sensitivity maintaining ratio (%) used in Examples and Comparative Example, represents a value calculated by the following formula:

$$\text{Sensitivity maintaining ratio (\%)} = \frac{\text{Initial sensitivity (initial energy for curing } \mu J/cm^2)}{\text{Sensitivity after storage for one week at } 55°C \text{ under a humidity of 0\% (energy for curing after storage } \mu J/cm^2)} \times 100$$

Further, to compare the deterioration degree in the developability, the printing plate was developed with a developer prepared by diluting the above-mentioned developer stock solution five times with water, and a developer ink (SPO-I, tradename, manufactured by Konica Co., Ltd.) was placed thereon to evaluate the staining degree of the non-image portion. The evaluation standards were as follows.

5: Not stained at all.
4: Very slightly stained.
3: Slightly stained.
2: Substantially stained.
1: Ink remained over the entire non-image portion

Pencil scratching test

By means by a pencil scratching tester (manufactured by Marubishi Kagaku Kikai Seisakusho K.K.), the photosensitive lithographic printing plate was scratched from above the protective layer by a pencil having a hardness of 3H under a load of 300 g, whereupon the degree of damage to the protective layer was evaluated. The evaluation standards were as follows.

5: No damage was observed at all on the surface of the protective layer.
4: No peeling was observed, although a mark was observed on the surface of the protective layer.
3: Slight peeling of the protective layer was observed.
2: Substantial peeling of the protective layer was observed.
1: The protective layer was completely peeled.

Allowance for development

A half of the photosensitive lithographic printing plate was light-shield and irradiated for one minute with a light of from 480 to 490 nm obtained from a 500 W xenon lamp (UXL-500D-O, manufactured by Ushio Electric Co., Ltd) through a glass filter (Y-47 and KL-49, manufactured by Toshiba Glass K.K.) from 50 cm thereabove. Then, the photosensitive lithographic printing plate was developed with a developer prepared by diluting the above-mentioned developer stock solution various diluting times with water, and a developer ink SPO-I (manufactured by Konica K.K.) was placed thereon, whereupon the allowable range of the number of diluting times of the developer wherein the image portion was completely wetted by the ink, and the non-image portion was not stained by the ink, was determined.

Table 1

| | | | | Examples | | | | | | | |
|---|---|---|---|---|---|---|---|---|---|---|---|
| | | | | 1 | 2 | 3 | 4 | 5 | 6 | 7 | 8 |
| Protective layer components | ① | Component (a) | | 70 parts | 60 parts | 50 parts | 40 parts | 30 parts | – | 50 parts | 50 parts |
| | ② | Component (a) | | – | – | – | – | – | 50 parts | – | – |
| | ③ | Component (b) | | 30 parts | 40 parts | 50 parts | 60 parts | 70 parts | 50 parts | – | – |
| | ④ | Component (b) | | – | – | – | – | – | – | 50 parts | – |
| | ⑤ | Component (b) | | – | – | – | – | – | – | – | 50 parts |
| | ⑥ | Other | | – | – | – | – | – | – | – | – |
| | ⑦ | Other | | – | – | – | – | – | – | – | – |
| | ⑧ | Other | | – | – | – | – | – | – | – | – |
| Evaluation results | Initial sensitivity ($\mu J/cm^2$) | | | 68 | 68 | 68 | 68 | 72 | 68 | 68 | 68 |
| | Sensitivity-maintaining ratio (%) | | | 95 | 95 | 98 | 95 | 95 | 95 | 98 | 95 |
| | Staining of non-image portion | | | 4 | 4 | 5 | 5 | 5 | 3 | 3 | 3 |
| | Pencil scratching test | | | 3 | 5 | 5 | 5 | 4 | 5 | 5 | 5 |
| | Allowance for development | | | 3-17 | 3-17 | 3-18 | 3-18 | 3-18 | 3-15 | 3-15 | 3-14 |

EP 0 738 929 A2

Table 2

| | | | Comparative Examples | | | | | | | |
|---|---|---|---|---|---|---|---|---|---|---|
| | | | 1 | 2 | 3 | 4 | 5 | 6 | 7 | 8 |
| Protective layer components | ① | Component (a) | 100 parts | 80 parts | 20 parts | – | 50 parts | 50 parts | – | 50 parts |
| | ② | Component (a) | – | – | – | – | – | – | – | – |
| | ③ | Component (b) | – | 20 parts | 80 parts | 100 parts | – | – | – | – |
| | ④ | Component (b) | – | – | – | – | – | – | – | – |
| | ⑤ | Component (b) | – | – | – | – | – | – | – | – |
| | ⑥ | Other | – | – | – | – | 50 parts | – | – | – |
| | ⑦ | Other | – | – | – | – | – | 50 parts | – | – |
| | ⑧ | Other | – | – | – | – | – | – | 100 parts | 50 parts |
| Evaluation results | | Initial sensitivity ($\mu$J/cm$^2$) | 68 | 68 | 80 | 120 | 68 | 68 | 76 | 70 |
| | | Sensitivity-maintaining ratio (%) | 90 | 90 | 95 | 95 | 95 | 95 | –※ | –※ |
| | | Staining of non-image portion | 3 | 3 | 3 | 4 | 3 | 2 | 1 | 1 |
| | | Pencil scratching test | 1 | 2 | 2 | 1 | 1 | 1 | 5 | 2 |
| | | Allowance for development | 3-13 | 3-14 | 4-18 | 5-18 | 4-18 | 3-13 | 3-13 | 3-13 |

In Tables 1 and 2, the protective layer components represent the following:

① Gosenol GL-03 (manufactured by Nippon Gosei Kagaku Kogyo K.K.): weight average molecular weight 17,200

9

② Gosenol GL-05 (manufactured by Nippon Gosei Kagaku Kogyo K.K.): weight average molecular weight 29,400

③ Polyvinyl pyrrolidone K-30 (manufactured by Tokyo Kasei Kogyo K.K.): weight average molecular weight 40,000

④ Polyvinyl pyrrolidone K-60 (manufactured by Tokyo Kasei Kogyo K.K.): weight average molecular weight 220,000

⑤ Polyvinyl pyrrolidone (70 mol%)-vinyl acetate ( 30 mol%) copolymer: weight average molecular weight 50,000

⑥ Polyvinyl pyrrolidone K-15 (manufactured by Tokyo Kasei Kogyo K.K.): weight average molecular weight 10,000

⑦ Polyvinyl pyrrolidone K-90 (manufactured by Tokyo Kasei Kogyo K.K.): weight average molecular weight 630,000

⑧ Carboxymethylcellulose CMC Disel 1201 (manufactured by Disel Kagaku Kogyo K.K.)

In Table 2, symbol - ※ means that development was impossible.

EXAMPLES 9 TO 12 AND COMPARATIVE EXAMPLES 9 TO 12

In Example 3 and Comparative Example 1, the coated amount of the protective layer was changed as shown in Table 3, the evaluations were carried out in the same manner as described above. The results are shown in Table 3.

Table 3

| | | Example 9 | Example 10 | Example 11 | Example 12 | Comparative Example 9 | Comparative Example 10 | Comparative Example 11 | Comparative Example 12 |
|---|---|---|---|---|---|---|---|---|---|
| Protective layer components | | same as in Example 3 | same as in Example 3 | same as in Example 3 | same as in Example 3 | same as in Comparative Example 1 | same as in Comparative Example 1 | same as in Comparative Example 1 | same as in Comparative Example 1 |
| Coated amount (g/m$^2$) | | 0.5 | 3 | 7 | 12 | 0.5 | 3 | 7 | 12 |
| Evaluation results | Initial sensitivity ($\mu$J/cm$^2$) | 120 | 72 | 68 | 68 | 100 | 68 | 68 | 68 |
| | Sensitivity-maintaining ratio (%) | 95 | 98 | 98 | 95 | 80 | 95 | – Development impossible | – Development impossible |
| | Staining of non-image portion | 5 | 5 | 5 | 3 | 3 | 3 | 1 | 1 |
| | Pencil scratching test | 2 | 4 | 5 | 5 | 1 | 1 | 1 | 2 |
| | Allowance for development | 4-21 | 3-19 | 3-18 | 3-12 | 3-16 | 3-15 | 3-12 | 3-9 |

EXAMPLES 13 AND 14 AND COMPARATIVE EXAMPLE 13

The polymer binder and the protective layer components in the coating liquid for the photopolymerizable sensitive layer, and the coated amount of the protective layer, were as shown in table 4, and the following evaluations were carried out. The results are shown in Table 4.

Contact angle to water

Exposure was carried out in the same manner as in the measurement of the allowability for development, and development was carried out with a developer prepared by diluting the above-mentioned developer stock solution five times with water, whereupon the contact angle of the obtained image portion to water was measured. The larger the measured value, the higher the oleophilicity of the image portion i.e. the better the ink-affinity.

Rubber removal property and printing resistance

A photosensitive lithographic printing plate prepared in the same manner as in the foregoing Examples and Comparative Examples, was subjected to scanning exposure with a dose of 100 $\mu$J/cm$^2$ by a 75 mW air-cooled argon ion laser and then developed with a developer prepared by diluting the above-mentioned developer stock solution five times with water, whereupon wash gum SQW-3 (manufactured by Konica K.K.) was lined. The printing plate was subjected to printing by "Heidelberger GTO" printing machine, whereby the number of printed sheets (gum removal property) until the ink density of the printed matter became constant, the printing resistance and the staining of the non-image portion were evaluated.

Pencil scratching test

The evaluation was carried out in the same manner as in the above Examples and Comparative Examples.

Table 4

| | | Comparative Example 13 | Comparative Example 14 | Comparative Example 15 |
|---|---|---|---|---|
| Polymer binder for the photopolymerizable sensitive layer | | same as in coating liquid 1 for the photopolymerizable sensitive layer | Polymer binder-a | Polymer binder-a |
| Protective layer components | | same as in Example 3 | same as in Example 3 | same as in Comparative Example 1 |
| Coated amount of the protective layer (g/m$^2$) | | 5 | 5 | 5 |
| Evaluation results | Pencil scratching test | 5 | 5 | 2 |
| | Contact angle to water | 84 | 55 | 55 |
| | Rubber removal property | 6 | 20 | 20 |
| | Printing resistance | at least 100,000 sheets | 50,000 sheets | 50,000 sheets |
| Polymer binder-a:copolymer of isobutyl methacrylate/isobutyl acrylate/methyl methacrylate/methacrylic acid = 20/10/35/35 mol ratio, weight average molecular weight: 100,000. | | | | |

As is evident from the results in Tables 1 to 4, the photopolymerizable sensitive material of the present invention is well balanced and excellent with respect to various properties such as the sensitivity, developability, overcoat scratch resistance, storage stability, ink-affinity and printing resistance.

**Claims**

1. A photopolymerizable sensitive material which comprises a support, a photopolymerizable sensitive layer comprising (A) an addition polymerizable compound having at least one ethylenically unsaturated bond, (B) a photopolymerization initiator to be activated by active light rays and (C) a polymer binder, formed on the support, and a protective layer formed thereon, wherein said protective layer comprises at least (a) a polyvinyl alcohol and/or a polyvinyl alcohol derivative, and (b) a polyvinyl pyrrolidone having a weight average molecular weight of from 20,000 to 500,000 and/or a vinyl pyrrolidone copolymer containing at least 50 mol% of vinyl pyrrolidone as a copolymer component and having a weight average molecular weight of from 10,000 to 400,000, and the proportion of component (a) in the total amount of components (a) and (b) is from 25 to 75 wt%.

2. The photopolymerizable sensitive material according to Claim 1, wherein the saponification degree of the polyvinyl alcohol and/or the polyvinyl alcohol derivative is from 75 to 99 mol%.

3. The photopolymerizable sensitive material according to Claim 1, wherein the contact angle of the photopolymerizable sensitive layer to water is at least 60°.

4. The photopolymerizable sensitive material according to Claim 1, wherein the polymer binder contains from 2 to 30 mol% of an unsaturated carboxylic acid as a polymer component.

5. The photopolymerizable sensitive material according to Claim 1, wherein the coated amount of the protective layer is from 1 g/m$^2$ to 10 g/m$^2$.

6. The photopolymerizable sensitive material according to any one of Claims 1 to 5, wherein the photopolymerization initiator contains a sensitizer showing absorption of light rays in the visible light range and a hexaarylbiimidazole compound.

7. The photopolymerizable sensitive material according to any one of Claims 1 to 5, wherein the photopolymerization initiator contains a sensitizer showing absorption of light rays in the visible light range and a titanocene compound.

8. The photopolymerizable sensitive material according to Claim 1, wherein the polymer binder contains from 2 to 30 mol% of an unsaturated carboxylic acid as a polymer component, and the coated amount of the protective layer is from 1 g/m$^2$ to 10 g/m$^2$.

9. The photopolymerizable sensitive material according to any one of Claims 1 to 8, wherein the weight average molecular weight of the polyvinyl alcohol and/or the polyvinyl alcohol derivative is from 4,000 to 100,000.